**Europäisches Patentamt**

**European Patent Office**

**Office européen des brevets**

(19)

(11) Publication number : **0 385 181 B1**

(12)

# EUROPEAN PATENT SPECIFICATION

(45) Date of publication of patent specification :
05.07.95 Bulletin 95/27

(51) Int. Cl.⁶ : **H04N 5/50,** H04N 7/10,
H04B 1/26, H03D 7/16

(21) Application number : **90102855.5**

(22) Date of filing : **14.02.90**

(54) Tuner station selecting apparatus.

(30) Priority : **17.02.89 JP 38581/89**
**27.02.89 JP 49569/89**

(43) Date of publication of application :
**05.09.90 Bulletin 90/36**

(45) Publication of the grant of the patent :
**05.07.95 Bulletin 95/27**

(84) Designated Contracting States :
**DE GB**

(56) References cited :
**WO-A-84/04637**
**US-A- 3 999 130**
**US-A- 4 581 643**

(73) Proprietor : **MATSUSHITA ELECTRIC**
**INDUSTRIAL CO., LTD.**
**1006, Oaza Kadoma**
**Kadoma-shi, Osaka-fu, 571 (JP)**

(72) Inventor : **Mishima, Akira**
**Shoji Ryo 3-5,**
**Togu-cho**
**Ibaraki-shi, Osaka-fu (JP)**
Inventor : **Kubo, Kazuhiko**
**1-58-102, Wakayamadai,**
**Shimamoto-cho**
**Mishima-gun, Osaka-fu (JP)**
Inventor : **Usui, Akira**
**3-8-24, Tsunoe-cho**
**Takatsuki-shi, Osaka-fu (JP)**

(74) Representative : **Eisenführ, Speiser & Partner**
**Martinistrasse 24**
**D-28195 Bremen (DE)**

EP 0 385 181 B1

## Description

The invention relates to a tuner station selecting apparatus comprising a first mixer for mixing the output signal from a first local oscillator with an input signal, a first PLL circuit including a first variable frequency divider to which the output signal of the first local oscillator is given, a first phase comparator to which the output signal of the first variable frequency divider and a reference frequency signal are given, and a first low-pass filter developing a control voltage for controlling the first local oscillator from the output signal of the first phase comparator, a second mixer for mixing an output signal from a second local oscillator with a signal from the first mixer, and having an IF amplifier, a second PLL circuit including a second variable frequency divider consisting of a pre-frequency-dividing section and a variable frequency dividing section, to which the output signal of the second local oscillator is given, a second phase comparator to which the output signal of the second variable frequency divider and the reference frequency signal are given, and a second low-pass filter developing the control voltage for controlling the second local oscillator from the output signal of the second phase comparator.

Generally, in, for example, a CATV in America, since the frequency zone thereof ranges to 54 through 440 MHz, a tuner station selecting apparatus of a double superheterodyne type is normally used. The tuner station selecting apparatus of a double superheterodyne type is also called an up, down tuner station selecting apparatus. It converts a received high-frequency signal into a first intermediate frequency signal by the conversion from the upper side station so as to attenuate the image interference signal, and thereafter, to convert it into a second intermediate frequency signal free from the image interference by the conversion from a lower side station.

Such double superheterodyne tuner station selecting apparatuses are for instance known from WO-A-8404637, and from a report published in "National Technical Report", Vol. 30, No. 1 of February 1984, pages 71-76.

In such tuner stations, the input sensitivity of the tuner is disturbed by harmonics of the output frequency of the second local oscillator returning to the RF input. Moreover, low order harmonics of the frequency divider of the first PLL circuit can interfere with the input signals to the tuner station.

It is an object of the present invention to provide an improved tuner station selecting apparatus which has a better performance, is simple in construction, and which avoids the disadvantages of the prior art devices.

In accordance with the invention, a tuner station selecting apparatus as defined in the preamble of claim 1 is characterized in that the first variable frequency divider consists of a pre-frequency-dividing section and a variable frequency dividing section, the pre-frequency-dividing section having a sufficiently large dividing ratio that the low order harmonics of its output frequency do not interfere with the frequency range of the input signal, that the pre-frequency-dividing section is placed within a tuner housing member containing the RF and IF components, whereas the variable frequency dividing section is placed outside the tuner housing, and that the second variable frequency divider receives its input signal from the second local oscillator via an output of the IF amplifier.

The coupling out of the frequency of the second local oscillator through the mixer and the output of the second IF amplifier to the pre-frequency divider of the second PLL circuit has the advantage that the harmonics of the output frequency of the second local oscillator is avoided from returning to the RF input, so that less interference signals are developed which would disturb the input sensitivity of the tuner station. The avoidance of an additional output terminal for coupling out the frequency of the second local oscillator at the tuner housing member has the advantage that output coupling filters like passing capacitors are not necessary, so that costs are reduced. Furthermore, the splitting of the first variable frequency divider into a pre-frequency dividing section and a variable frequency dividing section with certain frequency dividing ratios, and the placement of the pre-frequency dividing section within the tuner housing member, and of the variable frequency dividing section outside the tuner housing member, has the advantage that interferences are reduced further.

A preferable embodiment of the tuner station selecting apparatus in accordance with the present invention is characterized in that the frequency division ratio of the pre-frequency dividing section of the first variable frequency divider is set larger than the frequency division ratio of the pre-frequency dividing section of the second frequency divider.

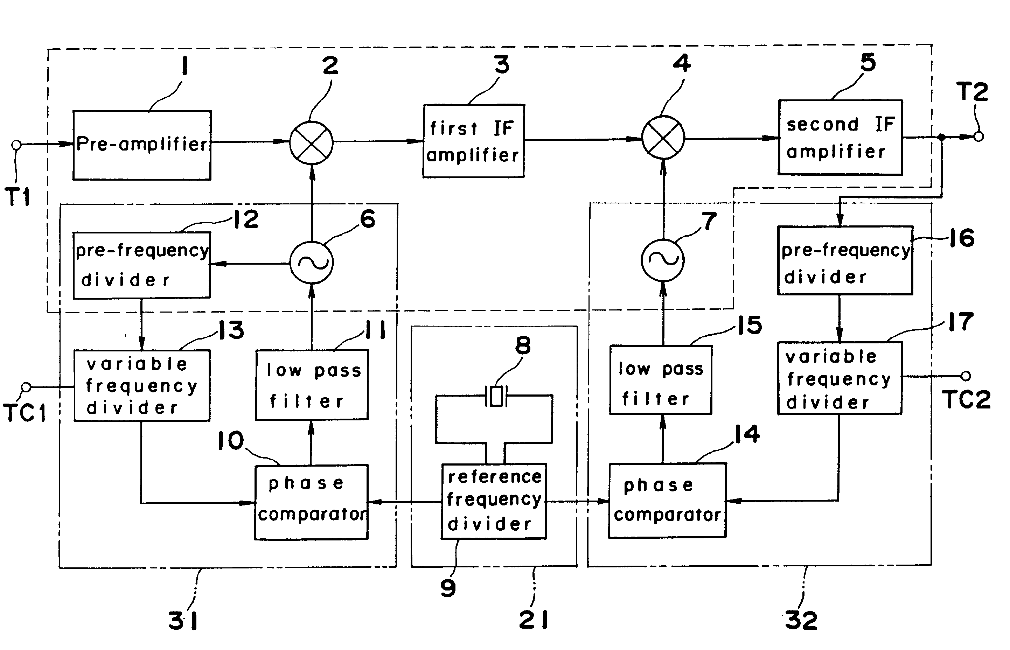

These and other objects and features of the present invention will become apparent from the following description taken in conjunction with the preferred embodiment thereof with reference to the accompanying drawing.

Referring now to the drawing, there is shown a block diagram of the basic construction of a tuner station selecting apparatus according to an embodiment of the invention. The block surrounded with broken lines shows a tuner housing member.

In the tuner station selecting apparatus, there is provided a first PLL circuit 31 including a first pre-frequency-divider 12, a first variable frequency divider 13, the dividing ratio of which is controlled at an input terminal TC1, a first phase comparator 10 and a first low-pass filter 11 in connection with a first local oscillator 6. There is provided a second PLL circuit 32 including a second pre-frequency-divider 16 for frequency-dividing by a certain uniform frequency division ratio the output frequency of the second local oscillator 7, a second variable frequency divider 17 to which the signal from the second pre-frequency-divider 16 is inputted, with the frequency division ratio thereof being changed by a control signal from the input terminal TC2, a second phase comparator 14 for comparing in phase the signal from the second variable frequency divider 17 with a reference frequency signal from a reference frequency divider 9 of a reference frequency signal generating circuit 21, a second low-pass filter 15 providing a control voltage for controlling the oscillation frequency of the second local oscillator 7 from the output of the second phase comparator 14. The reference frequency signal generating circuit 21 is adapted to be used in common by the first and second PLL circuits 31, 32.

A conventional solution would be to feed the oscillation output signal of the second local oscillator 7 to the second pre-frequency-divider 16 through an output terminal with the output terminal for the exclusive use being provided in the tuner housing member. In such a case, a through capacitor and so on are inevitably used and many connection portions are provided, with a problem that the design of the tuner housing member is made complicated.

The station selecting apparatus according to the embodiment of the present invention includes a pre-amplifier 1, a first mixer 2, a first intermediate frequency amplifier 3, a second mixer 4, a second intermediate frequency amplifier 5, a first local oscillator 6, a second local oscillator 7, a crystal oscillator oscillating circuit 8, a reference frequency divider 9, first, second phase comparators 10, 14, first, second low-pass filters 11, 15, first, second pre-frequency-dividers 12, 16, first, second variable frequency dividers 13, 17, with the broken lines in the drawing showing a tuner housing member. The characteristics of the present embodiment are that the input into the second pre-frequency-divider 16 is obtained from the output of the second intermediate frequency amplifier 5.

The respective frequency ratios N, M of the first, second pre-frequency-dividers 12, 16 to be respectively contained in the first and second PLL circuits 31, 32 are selected as follows.

$$N > M \quad (1)$$

In the embodiment, a first intermediate frequency is 965 M Hz in the first mixer 2. The oscillation frequency of the first local oscillator 7 varies in accordance with the control signal from the input terminal TC1 within the range of 1056.25 through 1730.25 M Hz. For example, when the two channels of Japanese television broadcasting is received, the frequency of the signal to be received from among the high-frequency signals from the input terminal T1 is 96 through 103 M Hz. If the frequency division ratio of the pre-frequency-divider 12 is 1 : 256 when television broadcasting of two channels has been received with the oscillation frequency of the first local oscillator 6 being 1062.25 M Hz, the 24th higher harmonic of the pre-frequency-divider 12 is generated near the frequency 99.58 M Hz. The degree of the higher harmonic which becomes interferences with respect to the input signal becomes higher than in the prior art conventional tuner station selecting apparatus, so that the influences become smaller so as to restrain the interferences with respect to the received signal.

The frequency change $\Delta f$ per step in the minimum fine adjustment frequency of the first local oscillator 6, namely, the frequency per step in the movable frequency divider 13 is as follows.

$$\Delta f = 256 \times fr = 256 \, (K \, Hz) \quad (2)$$

wherein the frequency of the reference frequency signal from the reference frequency signal generating circuit 21 is fr (= 1 K Hz). In the conventional tuner station selecting apparatus, the frequency change $\Delta F$ per step in the variable frequency divider 13 is 64 k Hz, so that the received frequency may be changed for each 64 K Hz. In the embodiment, in the second pre-frequency-divider 16 the second PLL circuit 32 is provided with, the frequency division ratio is set at 1:64. Accordingly, the change in the oscillation frequency of the second local oscillator 7 per step of the variable frequency divider 17 by the control signal from the input terminal TC2 is considered 64 K Hz. Despite the selection of the large frequency division ratio of the first pre-frequency-divider 12 the first PLL circuit 21 is provided with, the received frequency may be changed for each 64 K Hz.

At a switching operation of the received frequency, the second PLL circuit 32 is interrupted. When the second PLL circuit 32 is operated again if the oscillation frequency of the second local oscillator 7 composed of a voltage control type of oscillator is transitionally changes due to factors such as temperature, humidity and so on, the second PLL circuit 32 locks in phase the output signal of the variable frequency divider 17 with respect to the reference frequency signal from the reference frequency signal generating circuit 21. The oscillation frequency of the second local oscillator 7 is correctly set at a value corresponding to the control signal from the input terminal TC2, so that no error operations in the station selection are caused.

According to the tuner station selecting apparatus of the invention, the oscillation frequency of the second local oscillator is set so that the output signal of the second variable frequency divider the second PLL circuit is provided with is set to be locked in phase into the reference frequency signal. When the second PLL circuit is activated again if the operation of the second PLL circuit is interrupted and the oscillation frequency of the second local oscillator changes due to the external factors such as temperature, humidity and so on at the switching operation or the like of the received frequency, the oscillation frequency of the second local oscillator is correctly set to a value to be prescribed by the frequency division ratio of the second movable frequency divider. Accordingly, the station selecting operation is not effected at the switching operation of the received frequency.

Also, the frequency division ratio of the first pre-frequency-divider of the first PLL circuit may be selected so that the higher harmonic which interferes with the received signal in the higher harmonics of the output signal becomes comparatively higher in order. Therefore, the bad influences upon the received signals by the output signal of the first pre-frequency-divider may be reduced.

The input signal at the terminal T1 is fed to the first mixer 2 through the pre-amplifier 1. The first mixer 2 converts the input signal into the first intermediate frequency signal by the first local oscillator 6 so as to feed it into the first intermediate frequency amplifier 3. The first local oscillator 6 is fixedly divided in frequency by the first pre-frequency-divider 12, and the frequency dividing output thereof is variably divided in frequency by the first variable frequency divider 13. The output of the first variable frequency divider 13 is compared in phase with the output provided through the frequency division, by the reference frequency divider 9, of the reference oscillation frequency caused in the crystal oscillator oscillating circuit 8 by the first phase comparator 10. The detection output of the first phase comparator 10 effects the frequency control of the first local oscillator 6 through the first low-pass filter 11. The oscillation frequency of the first local oscillator 6 is higher by the first intermediate frequency than the frequency of the input signal.

The output of the first mixer 2 is fed into the second mixer 4 through the first intermediate frequency amplifier 3, is converted in the frequency with respect to the oscillation frequency of the second local oscillator 7 to obtain the second intermediate frequency signal so as to obtain the output from the terminal T2 through the second intermediate amplifier 5. The oscillation frequency of the second local oscillator 7 feeds into the second pre-frequency-divider 16 through the terminal T2, the frequency signal of the second local oscillator 7 to be leaked through the second intermediate frequency amplifier 5 and the output is fed into the second variable frequency divider 17. The second pre-frequency-divider 16 and the second variable frequency divider 17 may be integrated, and the frequency divider may contain the zone amplifier of the second local oscillator frequency. The frequency of the frequency divider is compared in phase with the signal of the reference frequency divider 9 by the second phase comparator 14. The detection output thereof controls the oscillation frequency of the second local oscillator 7 through the second low-pass filter 15.

As is clear from the foregoing description, according to the arrangement of the present invention, as the signal for phase-controlling the oscillation frequency of the second local oscillator 7, the second local oscillator frequency signal which leaks into the output of the second intermediate frequency amplifier 5 is obtained. The signal is fed into the external circuit (pre-frequency-divider 16, a variable frequency divider 17) so as to reduce the number of the connection terminals. As a result, the external connection portion of the tuner housing member, i.e., the connection location using the through capacitor may be reduced so as to reduce the cost of the parts, thus realizing a tuner station selecting apparatus which is more stable in higher frequency and is simpler in construction.

## Claims

1. A tuner station selecting apparatus comprising
   - a first mixer (2) for mixing the output signal from a first local oscillator (6) with an input signal (T1);
   - a first PLL circuit (31) including a first variable frequency divider (12, 13) to which the output signal of the first local oscillator (6) is given, a first phase comparator (10) to which the output signal of the first variable frequency divider (12, 13) and a reference frequency signal (8, 9) are given, and a first low-pass filter (11) developing a control voltage for controlling the first local oscillator (6) from the output signal of the first phase comparator (10);
   - a second mixer (4) for mixing an output signal from a second local oscillator (7) with a signal from the first mixer (2), and having an IF amplifier (5);
   - a second PLL circuit (32) including a second variable frequency divider (16, 17) consisting of a pre-frequency-dividing section (16) and a variable frequency dividing section (17), to which the output signal of the second local oscillator (7) is given, a second phase comparator (14) to which the output signal of the second variable frequency divider (16, 17) and the reference frequency signal (8, 9) are given, and a second low-pass filter (15) developing the control voltage for controlling the second local oscillator (7) from the output signal of the second phase comparator (14);
   characterized in that
   - the first variable frequency divider (12, 13) consists of a pre-frequency-dividing section (12) and a variable frequency dividing section (13), the pre-frequency-dividing section (12) having a sufficiently large dividing ratio that the low order harmonics of its output frequency do not interfere with the frequency range of the input signal;
- that the pre-frequency-dividing section (12) is placed within a tuner housing member containing the RF and IF components (1-7), whereas the variable frequency dividing section (13) is placed outside the tuner housing; and
- that the second variable frequency divider (16, 17) receives its input signal from the second local oscillator (7) via an output (T2) of the IF amplifier (5).

2. A tuner station selecting apparatus in accordance with the claim 1, wherein the frequency division ratio of the pre-frequency-dividing section (12) of the first variable frequency divider (12, 13) is set larger than the frequency division ratio of the pre-frequency-dividing section (16) of the second frequency divider (16, 17).

**Patentansprüche**

1. Senderabstimmvorrichtung mit
- einer ersten Mischstufe (2) zum Mischen des Ausgangssignals eines ersten Oszillators (6) mit einem Eingangssignal (T1);
- einer ersten PLL-Schaltung (31), die einen ersten variablen Frequenzteiler (12, 13), dem das Ausgangssignal des ersten Oszillators (6) zugeführt wird, einen ersten Phasenkomparator (10), dem das Ausgangssignal des ersten variablen Frequenzteilers (12, 13) und ein Referenzfrequenzsignal (8, 9) zugeführt werden, und ein erstes Tiefpaßfilter (11), das eine Steuerspannung zum Steuern des ersten Oszillators (6) aus dem Ausgangssignal des ersten Phasenkomparators (10) ableitet, enthält;
- einer zweiten Mischstufe (4), die einen ZF-Verstärker (5) aufweist, zum Mischen des Ausgangssignals eines zweiten Oszillators (7) mit dem Signal der ersten Mischstufe (2);
- einer zweiten PLL-Schaltung (32), die einen zweiten variablen Frequenzteiler (16, 17) aufweist, der einen Vorfrequenzteilerabschnitt (16) und einen variablen Frequenzteilerabschnitt (17) enthält und dem das Ausgangssignal des zweiten Oszillators (7) zugeführt wird, sowie einen zweiten Phasenkomparator (14), dem das Ausgangssignal des zweiten variablen Frequenzteilers (16, 17) und das Referenzfrequenzsignal (8, 9) zugeführt werden, und ein zweites Tiefpaßfilter (15), das eine Steuerspannung zum Steuern des zweiten Oszillators (7) aus dem Ausgangssignal des zweiten Phasenkomparators (14) ableitet, enthält;
dadurch gekennzeichnet,
- daß der erste variable Frequenzteiler (12, 13) aus einem Vorfrequenzteilerabschnitt (12) und einem variablen Frequenzteilerabschnitt (13) besteht und der Vorfrequenzteilerabschnitt (12) ein genügend großes Teilerverhältnis aufweist, so daß Harmonische niedriger Ordnung der Ausgangsfrequenz nicht den Frequenzbereich des Eingangssignals stören;
- daß der Vorfrequenzteilerabschnitt (12) innerhalb eines Gehäuseteils der Senderabstimmvorrichtung angeordnet ist, das die HF- und ZF-Komponenten (1-7) enthält, während der variable Frequenzteilerabschnitt (13) außerhalb dieses Gehäuseteils angeordnet ist; und
- daß der zweite variable Frequenzteiler (16, 17) sein Eingangssignal vom zweiten Oszillator (7) über einen Ausgangsanschluß (T2) des ZF-Verstärkers (5) erhält.

2. Senderabstimmvorrichtung nach Anspruch 1, dadurch gekennzeichnet, daß das Frequenzteilerverhältnis des Vorfrequenzteilerabschnittes (12) des ersten variablen Frequenzteilers (12, 13) größer als das Frequenzteilerverhältnis des Vorfrequenzteilerabschnittes (16) des zweiten Frequenzteilers (16, 17) ist.

**Revendications**

1. Appareil de sélection de stations pour syntoniseur, comprenant:
un premier mélangeur (2) servant à mélanger le signal de sortie d'un premier oscillateur local (6) avec un signal d'entrée (T1);
une première boucle à phase asservie, ou PLL, (31) comportant un premier diviseur de fréquence variable (12, 13) auquel le signal de sortie du premier oscillateur local (6) est fourni, un premier comparateur de phase (10) auquel le signal de sortie du premier diviseur de fréquence variable (12, 13) et un signal de fréquence de référence (8, 9) sont fournis, et un premier filtre passe-bas (11) établissant une tension de commande destinée à commander le premier oscillateur local (6) à partir du signal de sortie du premier comparateur de phase (10);
un deuxième mélangeur (4) servant à mélanger le signal de sortie d'un deuxième oscillateur local (7) avec un signal du premier mélangeur (2), et possédant un amplificateur de fréquence intermédiaire, ou IF, (5) ;

un deuxième circuit PLL (32) comportant un deuxième diviseur de fréquence variable (16, 17) consistant en une section de pré-division de fréquence (16) et une section de division de fréquence variable (17), auquel le signal de sortie du deuxième oscillateur local (7) est fourni, un deuxième comparateur de phase (14) auquel le signal de sortie du deuxième diviseur de fréquence variable (16, 17) et le signal de fréquence de référence (8, 9) sont fournis, et un deuxième filtre passe-bas (15) établissant la tension de commande permettant de commander le deuxième oscillateur local (7) à partir du signal de sortie du deuxième comparateur de phase (14); caractérisé en ce que:

le premier diviseur de fréquence variable (12, 13) consiste en une section de pré-division de fréquence (12) et une section de division de fréquence variable (13), la section de pré-division de fréquence (12) ayant un rapport de division suffisamment grand pour que les harmoniques d'ordre inférieur de son signal de sortie n'interfèrent pas avec la gamme de fréquence du signal d'entrée;

la section de pré-division de fréquence (12) est placée à l'intérieur d'un élément logeant le syntoniseur, qui contient les composants RF et IF (1-7), tandis que la section de division de fréquence variable (13) est placée à l'extérieur du logement du syntoniseur; et

le deuxième diviseur de fréquence variable (16, 17) reçoit son signal d'entrée de la part du deuxième oscillateur local (7) via une sortie (T2) de l'amplificateur IF (5).

2.  Appareil de sélection de stations pour syntoniseur selon la revendication 1, où le rapport de division de fréquence de la section de pré-division de fréquence (12) du premier diviseur de fréquence variable (12, 13) est fixé à une valeur plus grande que le rapport de division de fréquence de la section de pré-division de fréquence (16) du deuxième diviseur de fréquence (16, 17).

Pre-amplifier (1), first IF amplifier (3), second IF amplifier (5), pre-frequency divider (12), pre-frequency divider (16), variable frequency divider (13), variable frequency divider (17), low pass filter (11), low pass filter (15), phase comparator (10), phase comparator (14), reference frequency divider (9), mixers (2), (4), oscillators (6), (7), crystal (8). Terminals T1, T2, TC1, TC2. Blocks 21, 31, 32.